# FASCICULE DE BREVET EUROPEEN

(11) **EP 1 058 857 B1**
(45) Date de publication et mention de la délivrance du brevet: **28.08.2002**
(21) Numéro de dépôt: 99904936.4
(22) Date de dépôt: 23.02.1999
(51) Int. Cl.: G02B 5/04

(54) **PROCEDE DE FABRICATION COLLECTIVE DE MICRORELIEFS, ET NOTAMMENT DE MICROPRISMES, PAR MICRO-USINAGE, ET OUTILS POUR LA MISE EN OEUVRE DU PROCEDE**
VERFAHREN UND WERKZEUGE ZUR KOLLEKTIVEN HERSTELLUNG VON MIKRORELIEFS, INSBESONDERE VON MIKROPRISMEN, DURCH MIKROBEARBEITUNG
METHOD FOR COLLECTIVELY PRODUCING MICRORELIEFS, AND IN PARTICULAR MICROPRISMS, BY MICROMACHINING, AND TOOLS FOR IMPLEMENTING SAID METHOD

(30) Priorité: 24.02.1998 FR 9802198
(43) Date de publication de la demande: 13.12.2000
(73) Titulaire: COMMISSARIAT A L'ENERGIE ATOMIQUE, 75015 Paris (FR)
(72) Inventeur: RABAROT, Marc, F-38170 Seyssinet (FR); MARTY, Vincent, F-84240 La Tour d'Aigues (FR)
(74) Mandataire: Des Termes, Monique
(86) Numéro de dépôt international: FR9900403
(87) Numéro de publication internationale: WO99044081

(56) Documents cités:
- EP-A- 0 532 229
- EP-A- 0 684 105
- WO-A-96/05525
- US-A- 3 254 556
- US-A- 5 069 003
- PATENT ABSTRACTS OF JAPAN vol. 008, no. 271 (P-320), 12 décembre 1984 & JP 59 139002 A (SONY KK), 9 août 1984 cité dans la demande

## Description

### Domaine technique et art antérieur

L'invention concerne l'usinage de composants miniaturisés, par exemple de composants micro-optiques.

Elle concerne en particulier un procédé et un dispositif pour la fabrication collective de microreliefs, et notamment de microprismes, par micro-usinage.

L'invention se rapporte ainsi aux domaines des micro-composants, des composants de micro-optique, des microlasers ou des amplificateurs guides d'onde solides pompés par diodes. Elle se rapporte à la micro-technologie en général.

Les composants de micro-optique sont utilisés pour des applications en optique ou en optronique militaire et civile (télécommunications, industrie de grande consommation : "compact disc", vidéo...), qui nécessitent une miniaturisation des composants et des systèmes, et ceci pour des raisons économiques et/ou technologiques. Ces composants peuvent être obtenus collectivement par des techniques de lithographie et/ou de gravure de matériaux optiques ou optroniques, dopés ou non, comme la silice, ou d'autres matériaux cristallins comme le niobate ou le tantalate de lithium (LiNbO₃ ou LiTaO₃) ou encore des polymères ou des nouveaux matériaux organiques.

Les microlasers et les amplificateurs guides d'ondes sont des lasers solides monolithiques de petites dimensions pompés par diode laser. Leur avantage principal est leur structure, qui consiste en un empilement de multicouches qui permet de mettre en oeuvre des procédés de fabrication collective du type de ceux utilisés en micro-électronique. Ainsi, on peut réaliser des composants fiables, à l'aide d'une technologie de production de masse, potentiellement à très faible coût (comme en micro-électronique).

Des microlasers sont par exemple décrits dans l'article de N. Mermilliod et al. Paru dans Applied Physics Letters, vol. 59, n° 27, p. 3519 (1991).

D'autres microlasers sont décrits dans le document EP-653 824.

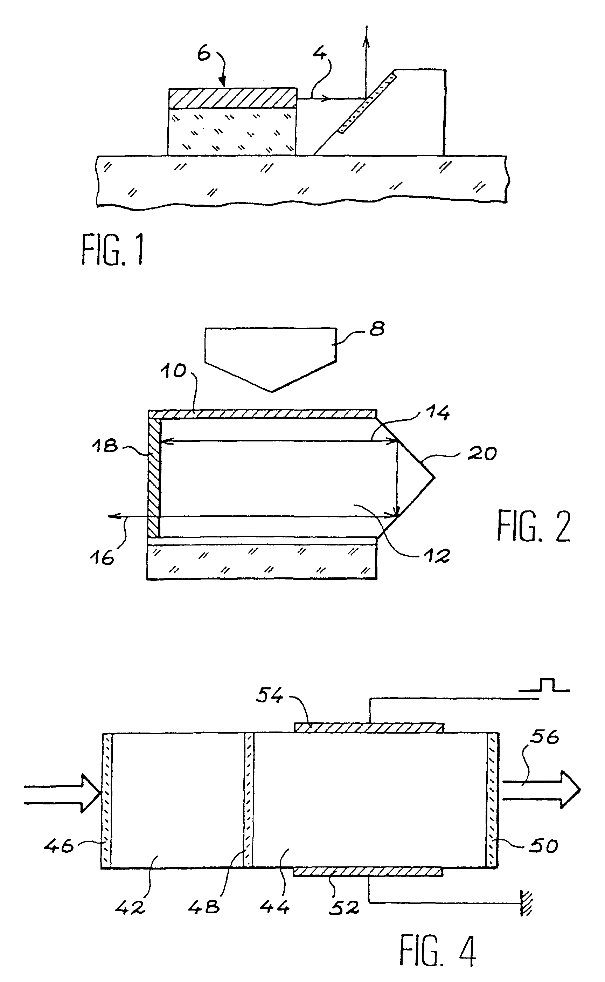

Pour certains microlasers, ou dans les amplificateurs guide d'onde, le faisceau laser n'est pas émis perpendiculairement au plan du substrat, mais parallèlement à celui-ci (parallèlement au guide optique). Pour que le laser ou l'amplificateur fonctionne bien, on cherche donc à usiner les faces latérales de façon à obtenir un très bon parallélisme entre elles, et une faible rugosité (un état poli) sur chacune d'elles. Dans certains cas, il peut être intéressant de renvoyer le faisceau verticalement ou perpendiculairement au plan du substrat, comme dans le cas des lasers à cavités verticales (VCSEL). Une solution technologique consiste alors, comme illustré sur la figure 1, à positionner un micromiroir 2 à 45° en face du faisceau de sortie 4 du laser ou du guide 6. De même, il peut être intéressant de positionner un micro-miroir en entrée d'un dispositif microlaser.

Par ailleurs, il peut être utile, pour certains types de cavités microlasers, de fabriquer collectivement des structures de micro-prismes directement dans un matériau laser ou électro-optique ; c'est le cas d'une cavité de microlaser impulsionnel à déclenchement actif par micro-modulateur, tel que décrit dans la demande EP-751 594.

Enfin, la fabrication de micro-prismes dans un matériau laser peut s'avérer nécessaire pour la réalisation de minilasers à pompage transverse, dont le principe de fonctionnement est rappelé sur la figure 2 : un faisceau de pompage 8 entre dans la cavité microlaser ou laser par un miroir d'entrée 10, et le pompage du milieu actif laser 12 donne naissance à une oscillation laser 14 dont il résultera une faisceau laser 16 émis à travers un miroir de sortie 18. Le faisceau oscille dans la cavité ente le miroir de sortie 18 et un microprisme 20 en fond de cavité.

Pour tous ces composants, se pose le problème de la réalisation des microprismes.

On connaît deux techniques de réalisation de microprismes de géométrie quelconque.

La première technique est décrite dans le document WO 96/05525. Il s'agit d'une méthode que l'on peut qualifier de "pseudo-collective", puisqu'elle permet de traiter collectivement, au cours des étapes de fabrication, des composants dont les ébauches sont préalablement assemblées une à une.

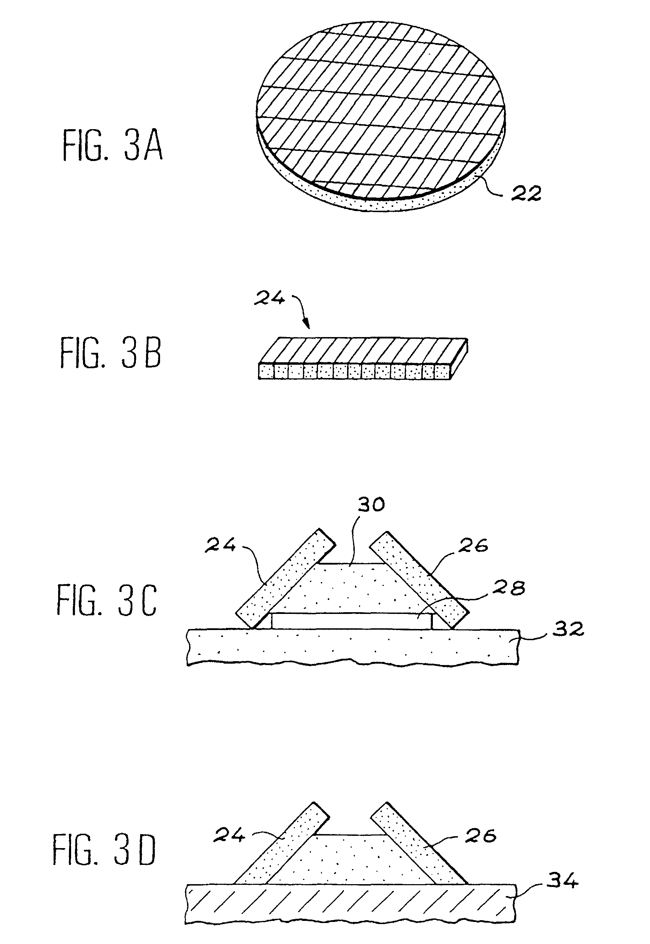

Les étapes de cette technique sont résumées sur les figures 3A à 3D. Une plaquette 22 de matériau pour microprismes (par exemple : de la silice) est découpée en barrettes 24, 26 de puces qui sont ensuite montées en blocs pour l'ébauche et le polissage des faces inclinées. Ce montage (figure 3C) est réalisé sur un support 30, incliné à l'angle α du prisme désiré, une cale 28 de collage et un support 32 de collage. Après collage, le support 32 et la cale 28 sont enlevés.

Ensuite, à l'aide d'un support 34 de polissage, on ébauche, puis on polit les barrettes 24, 26 sur une face, et éventuellement sur l'autre face (figure 3D).

Ces opérations sont essentiellement manuelles, et nécessitent de nombreuses sous-étapes de montage et de démontage qui s'avèrent généralement coûteuses.

De plus, ce procédé peut se révéler peu fiable car le contrôle des angles d'une pièce à l'autre dépend de nombreux paramètres eux-mêmes mal contrôlés, comme par exemple l'épaisseur du film de colle nécessaire à la fixation sur le support 30.

Et, surtout, cette méthode ne permet pas de traiter globalement un substrat comme une plaquette de microprismes, en vue d'une intégration dans un véritable microsystème avec, par exemple, une structure complémentaire, dont les motifs unitaires seraient auto-alignés collectivement (plaque à plaque).

La seconde technique est basée sur une technologie de type micro-électronique, et est décrite dans le document JP-59 139002. Dans ce cas, on réalise des matrices pour la réplication, et des microprismes par lithographie et gravure d'une structure multicouche. Pratiquement, il s'agit de déposer au moins deux couches de silice par une technique "CVD" (dépôt chimique en phase vapeur), et de contrôler leur vitesse de gravure respectives par la température d'un recuit pour chaque couche (de 700 à 1000°C). La vitesse de gravure de la (ou des) couche(s) supérieure(s) doit être plus élevée que celle de la (ou des) couches(s) inférieure(s). On obtient ainsi, par gravure chimique réactive (RIE) à travers les orifices du masque supérieur, des structures pyramidales dont l'angle peut être contrôlé pour réaliser des microprismes.

Cette technique est collective puisque l'on procède à une lithographie par masquage. Par contre, elle est relativement "lourde" (elle nécessite plusieurs niveaux de recuits et gravure), donc coûteuse. De plus, elle est "indirecte", car elle nécessite d'abord la fabrication de matrices et ensuite la réplication des structures. Enfin, l'épaisseur des structures, donc les dimensions verticales des zones optiquement utilisées, semble relativement limitée par les performances accessibles des procédés actuels de dépôt et de gravure (quelques µm à quelques 10 µm).

Dans le domaine des guides d'onde, en optique intégrée, que l'on souhaite coupler avec une fibre optique, se pose le problème de la qualité du couplage entre l'entrée, ou la sortie, du guide, et la fibre.

Pour obtenir de faibles pertes optiques, on cherche à avoir une faible rugosité des surfaces à mettre en contact. En général les procédés classiques de micro-découpe ne permettent pas d'obtenir directement la rugosité adéquate en bout de guide. Dans le cas, par exemple, de l'optique intégrée sur silicium, la solution actuellement la plus performante consiste à cliver le substrat, la couche active de silice se "casse" dans le prolongement du clivage, et l'état de surface de la silice obtenu en bout de guide est excellent. Le problème est que l'on ne contrôle pas bien la position du clivage par rapport au dispositif intégré sur la puce, ce qui réduit le rendement de fabrication des composants, et donc augmente le coût de fabrication.

Le document EP-532 229 décrit un procédé de découpe alignée suivie, dans la même opération que la découpe, d'un polissage de l'extrémité des guides à l'aide d'une lame de scie diamantée. Cette technique permet, à la fois de s'affranchir du problème de positionnement et d'obtenir un bon état de surface avec un faible coût.

Plus récemment, il a été décrit par H. Yokosuka et al. (1996, Electronic Components and Technology Conference, p. 487-493), une variante de ce procédé, utilisant un abrasif séparé de celui de la lame de scie, pendant la découpe. Cette approche permet d'améliorer considérablement l'état de finition de polissage des extrémités des guides ainsi découpés, et donc les performances des guides.

Le document US-A-3 254 556 décrit la fabrication d'un réseau monolithique de microprismes mais ne prévoit pas son découpage.

Les exemples ci-dessus montrent les problèmes techniques qui se posent de façon générique lors de la fabrication, collective ou automatisée, de microreliefs "optiques" miniaturisés, assemblés ou non en microsystèmes.

Les techniques d'obtention de surfaces polies de micro-composants lasers et de surfaces micro-optiques usinées, comme par exemple l'usinage et le polissage des faces d'un microprisme à 45° en silice ou en matériau laser (pour réaliser un miroir de renvoi "vertical" des faces d'entrée et/ou de sortie d'un microlaser ou d'un amplificateur guide d'onde), font appel à une succession d'étapes d'ébauche, de découpe, de rodage et de polissage qui nécessitent un nombre important de sous étapes de préparation des échantillons à traiter. De plus, l'enchaînement des étapes ne peut être considéré comme une technique véritablement collective, puisqu'au mieux on ne peut traiter les différents micro-composants que par barrettes qu'il faut rapporter sur un support pour réaliser une étape donnée. Or, dans certains cas, il est même nécessaire de traiter la fabrication des composants par plaquettes, de façon à rapporter en un bloc l'ensemble des composants sur un autre substrat contenant des éléments complémentaires du système ou du dispositif miniaturisé.

### Exposé de l'invention

L'invention apporte une solution originale à ces problèmes puisqu'elle permet de réaliser, avant la découpe, l'usinage de la structure, et éventuellement le polissage de la ou des surfaces actives, en une ou plusieurs étapes enchaînées sans montage et démontage des micro-composants ou de barrettes. Ces opérations peuvent être réalisées à l'aide d'une machine automatique, et la mise en oeuvre de cette technique permet d'abaisser le coût de fabrication, et/ou d'accroître les possibilités d'intégration, et/ou d'améliorer la fiabilité globale des composants.

L'invention a pour objet un procédé de fabrication, dans un substrat, de microcomposants présentant des microreliefs, comportant :
- une première étape de réalisation du micro-relief désiré par usinage mécanique du substrat, et
- simultanément à la première étape, ou après celle-ci, une deuxième étape de découpe des microcomposants dans le substrat.

L'invention concerne donc un procédé de fabrication de microreliefs avant découpe des composants selon la revendication 1. Les composants unitaires sont découpés dans la plaquette lors d'une étape postérieure à la (ou aux) opération(s) d'usinage et de finition à l'aide d'un outil de découpe, par exemple un outil classique comme une lame de scie diamantée.

On entend par micro-relief toute structure géométrique en trois dimensions obtenue par l'usinage rectiligne d'un substrat, ou d'une ou plusieurs couches déposées sur ce substrat.

L'usinage, dit rectiligne, est réalisé dans ce cas par l'usinage dans une seule direction située dans le plan du substrat.

La première étape d'usinage peut comporter deux sous-étapes : une sous-étape d'ébauche et une sous-étape de finition.

Le micro-relief peut être réalisé avec un seul outil déplacé à la surface du substrat, ou avec plusieurs outils travaillant simultanément ou successivement.

Les dimensions verticales des microreliefs sont, par exemple, de l'ordre de quelques dizaines de micromètres (par exemple : 10µm ou 20 µm ou 50 µm) à quelques centaines de micromètres (par exemple : 200 µm ou 400 µm ou 600µm).

Un micro-relief peut être, par exemple, une structure de microprisme ou de micromiroir dont l'état de surface requis après usinage est dit poli "optique" (de faible rugosité : environ 1µm PV ("Peak to Valley"), soit 100 nm RMS (moyenne quadratique)). Cet état de surface peut être obtenu dans la même opération que l'usinage d'ébauche, ou dans une seconde étape de finition, associée à la première étape.

L'invention concerne donc en particulier un procédé de fabrication collective (ou automatisé), qui permet d'usiner collectivement, dans un substrat ou une ou plusieurs couches déposées sur un substrat, des microreliefs (par exemple des microprismes ou des micromiroirs) avec un état de surface poli "optique" (de faible rugosité), dans la même opération que l'usinage du composant ou de la structure, ou dans une seconde étape de finition associée à une première étape d'ébauche.

La réalisation d'un microprisme met en oeuvre, par exemple, une lame abrasive à profil en "V".

On peut définir un microprisme comme un micro-relief à structure prismatique (avec une ou plusieurs faces inclinées), par exemple pour des applications optiques ; il est alors utilisé, dans ce cas, pour les propriétés de réflexion (miroir) ou de transmission (dioptre) sur les faces usinées, avec une qualité de polissage "optique".

Cette qualité de surface sous-entend qualitativement une faible rugosité définie visuellement soit par un état de poli miroir qui permet une "bonne" réflexion de la lumière (avec un taux de pertes optiques relativement faible), soit par un état de transparence (relativement faible taux de pertes optiques par transmission).

### Brève description des figures

De toute façon, les caractéristiques et avantages de l'invention apparaîtront mieux à la lumière de la description qui va suivre. Cette description porte sur les exemples de réalisation, donnés à titre explicatif et non limitatif, en se référant à des dessins annexés sur lesquels :
- La figure 1 représente une structure de microlaser associée à un micromiroir.
- La figure 2 représente une structure de minilaser à pompage transverse.
- Les figures 3A à 3D représentent des étapes d'un procédé de réalisation de microprismes.
- La figure 4 représente une structure de microlaser déclenché activement;
- Les figures 5A à 5E représentent un mode de réalisation d'un procédé selon l'invention pour la fabrication de microlasers déclenchés activement.
- Les figures 6A à 6C sont diverses formes de tranchées réalisables dans le cadre d'un procédé selon l'invention.
- La figure 7 est un exemple de réalisation de microprismes ou de micro-miroirs, selon l'invention.
- Les figures 8A et 8B représentent la réalisation, selon l'invention, de microcomposants comportant chacun un microlaser et un micromiroir de renvoi.

### Description détaillée de modes de réalisation de l'invention

Un premier exemple de réalisation de l'invention va être donné : il concerne la réalisation de microlasers à déclenchement actif.

Des structures de microlaser à déclenchement actif sont rappelées et décrites dans le document EP-724 316.

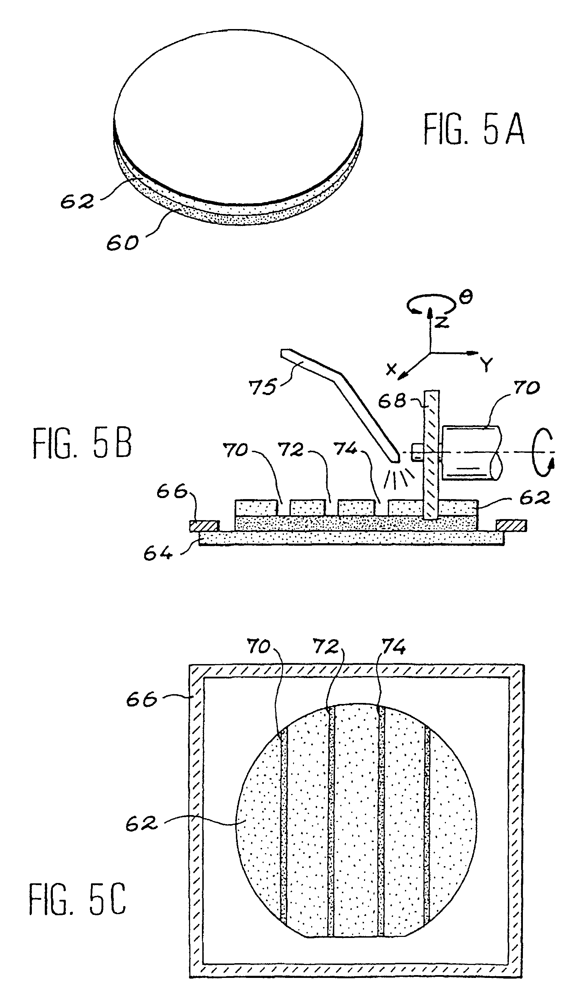

L'une de ces structures est illustrée sur la figure 4 ci-jointe, sur laquelle la référence 42 désigne le milieu actif laser et la référence 44 un matériau déclencheur, par exemple un matériau électro-optique tel que LiTaO₃.

Le milieu actif 42 du laser forme, avec un miroir d'entrée 46 et un miroir intermédiaire 48 une première cavité Fabry-Pérot. Le matériau déclencheur forme, avec le miroir intermédiaire 48 et le miroir de sortie 50, une deuxième cavité Fabry-Pérot. Le matériau déclencheur 44 peut être par exemple collé à la surface du miroir intermédiaire 48. Les deux cavités sont couplées. Le déclenchement se fait en modifiant la longueur optique du matériau déclencheur 44 par une action externe. Si l'on appelle L₁, n₁, λ₁ (L₂, n₂, λ₂) les longueurs, indices optiques et longueurs d'onde optique de résonance de la première cavité (de la deuxième cavité), il existe la relation : m₁λ₁=2n₁L₁ et m₂λ₂=2n₂L₂ avec m₁ et m₂ nombres entiers.

Si le matériau 44 est un matériau électro-optique, des électrodes de déclenchement 52, 54 sont placées perpendiculairement à l'axe du faisceau laser 56 de part et d'autre du matériau déclencheur 44. Si une tension V est appliquée entre ces électrodes, un champ électrique E=V/e, où e est la distance entre les électrodes (ce qui correspond à l'épaisseur du matériau électro-optique) en résulte. L'indice optique ni et par conséquent la longueur optique n₂L₂, du matériau électro-optique est modifié par l'action du champ E. Ceci affecte le couplage des deux cavités et modifie la réflectivité du miroir intermédiaire 48 vu par le milieu laser. En effet, si les longueurs d'onde de résonance des deux cavités coïncident (λ₁=λ₁ ou n₁L₁/n₂L₂=m₁/m₂) la réflectivité de la deuxième cavité (électro-optique) vue par la première cavité (matériau laser) sera minimum, et il n'y aura pas d'action laser. Ainsi, en agissant sur le champ E, on peut modifier les conditions de résonance du microlaser, dont la réflectivité de la deuxième cavité, et ainsi on peut réaliser le déclenchement actif.

Les étapes d'un procédé de réalisation selon l'invention sont illustrées sur les figures 5A à 5E.

La figure 5A représente l'assemblage d'une plaquette 60 de matériau actif laser (des exemples de tels matériaux sont donnés dans le document EP-653 824) et d'une plaquette 62 de matériau électro-optique (par exemple LiTaO₃).

Puis (figure 5B) la plaquette est fixée sur un film plastique autocollant 64, dont on peut choisir l'épaisseur et ajuster les propriétés d'adhérence de la colle par une insolation au rayonnement UV. L'ensemble est ensuite fixé sur un cadre métallique 66 qui permet les manipulations. Ce cadre est fixé sur une machine de découpe, par exemple par l'intermédiaire d'un support aspirant rectifié.

Cette machine comporte en outre une lame ou un disque 68 abrasif ainsi que des moyens 70 pour entraîner celui-ci en rotation.

La lame choisie ici est à faces planes et parallèles, pour usiner des tranchées verticales 70, 72, 74. Cette lame peut être une scie diamantée, utilisée comme meule pour l'ébauche et le polissage des structures.

Ce sont ensuite les paramètres de la machine qui sont ajustés (vitesse de rotation de la lame, vitesse d'avance dans le matériau, profondeur de coupe) en fonction du type de lame utilisé (type de la matrice dans laquelle sont noyés les grains d'abrasif (diamant ou autre), granulométrie et densité de cet abrasif, ...).

Dans certains cas (surtout pour les matériaux les plus durs), on divise le procédé en deux étapes au moins :
- une première étape d'ébauche, suivie (dans l'alignement des traits) :

- d'au moins une étape de finition ou de polissage, en général avec des grains d'abrasif plus fins.

Le procédé en deux étapes peut être effectué en une seule passe à l'aide d'une machine à double broche, la première montée avec la lame d'ébauche, et la seconde avec la lame de finition. Pour affiner l'état de surface et les défauts induits dans le matériau par l'usinage, il est possible d'utiliser un lubrifiant de coupe, mélangé à l'eau de refroidissement de la lame ou distribué séparément. Sur la figure 5B, un conduit 75 permet d'amener un fluide de refroidissement de la lame, par exemple de l'eau, avec ou sans lubrifiant.

Après cette étape, on obtient une structure usinée représentée en vue de dessus sur la figure 5C.

Une étape ultérieure de découpe selon une direction perpendiculaire à la direction des tranchées 70, 72, 74 (figure 5D) permet d'isoler des puces individuelles 76 de microlaser déclenché activement (figure 5E). Chaque puce peut avoir par exemple une forme en "T" qui permet à la fois de définir la largeur active de la cavité électro-optique et de permettre le dépôt et la prise des contacts électriques sur chacune des faces actives 77, 79.

Les paramètres du procédé, qui dépendent de la machine, de la lame et des conditions opératoires sont déterminés spécifiquement pour chaque type d'application (dimensions des microreliefs) et selon la nature du matériau constituant les prismes ou les faces réfléchissantes à usiner.

A titre d'exemple pour du "polisciage" de structures en LTO pour réaliser des microlasers déclenchés par une tension de commande externe (comme décrit ci-dessus), on a sélectionné les paramètres suivants :
- vitesse de rotation de la lame : 20 000 tr/mn.
- Vitesse d'avance de la lame : 0,5 à 1 mm/s.
- Profondeur de passe maximale :0,1 mm.
- Type de lame : matrice résinoïde Ref. Thermocarbon : 2,25-6A-3XQ-3
- Refroidissement de la lame : eau déionisée (sans lubrifiant).

L'aspect observé des flancs des motifs découpés est brillant et transparent, ce qui correspond à un état communément nommé poli "optique". La rugosité mesurée à l'aide d'un microscope interférométrique de marque Micromap, sur un champ d'environ 100x100 µm² avec une résolution spatiale d'environ 0,5 µm, est de l'ordre de 1 nm RMS (moyenne quadratique) et de 100 nm P-V (Peak to Valley : écart maximum d'amplitude).

Dans ces conditions de procédé, l'état de surface obtenu sur le matériau électro-optique est de type poli "optique", c'est-à-dire que les flancs usinés du matériau présentent un spectre transparent et brillant avec une rugosité d'environ 15 A RMS.

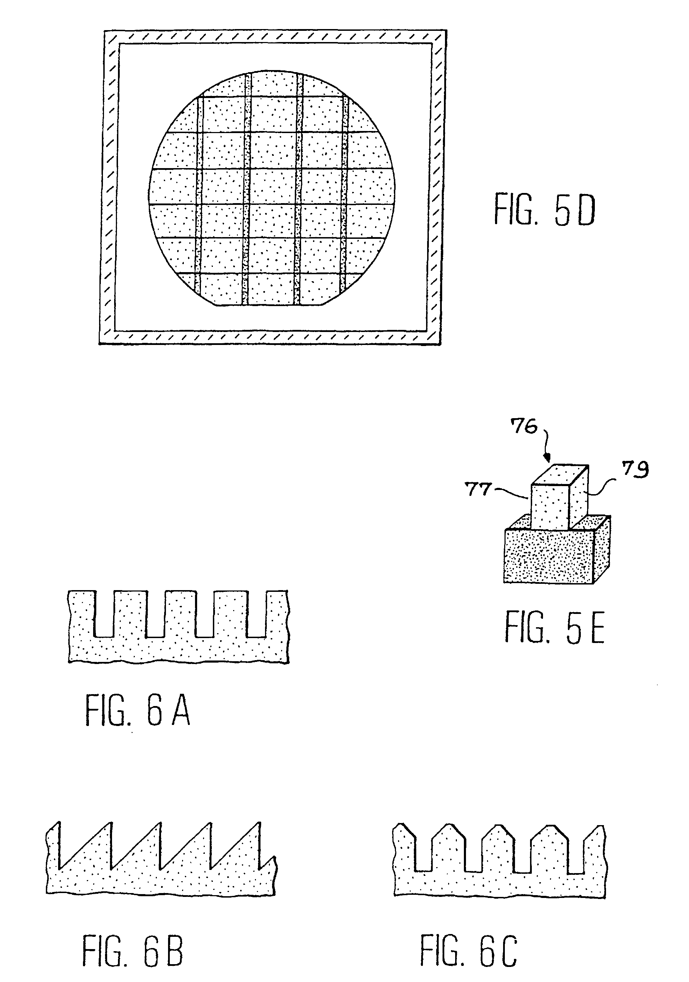

Le procédé décrit ci-dessus peut être adapté à d'autres formes de découpes et à d'autres matériaux. En particulier, les lames de scie peuvent être soit à faces planes et parallèles, par exemple pour usiner des tranchées verticales (figure 6A), soit avec une ou deux faces inclinées avec un angle prédéfini pour usiner des tranchées inclinées dont le profil est illustré en figure 6B. La combinaison de ces deux types de lames permet par exemple d'obtenir des tranchées biseautées dont le profil est illustré en figure 6C. De même, en combinant des traits (ou tranchées) orthogonaux ou d'un angle quelconque, on peut réaliser des reliefs de différentes structures, pyramidales par exemple.

En particulier, pour la réalisation de microprismes, on utilisera des lames de scies diamantées ayant un profil en "V", comme meules pour l'ébauche et le polissage des structures.

Par cette technique, à l'aide de lames de scies diamantées qui possèdent un biseau d'angle contrôlé en bout de lame, on peut réaliser l'ébauche de structures de microprismes à 90° dans des substrats de silice massive. On a pu vérifier à l'aide d'un projecteur de profil, que le contrôle de l'angle est possible à au moins 0,1° près.

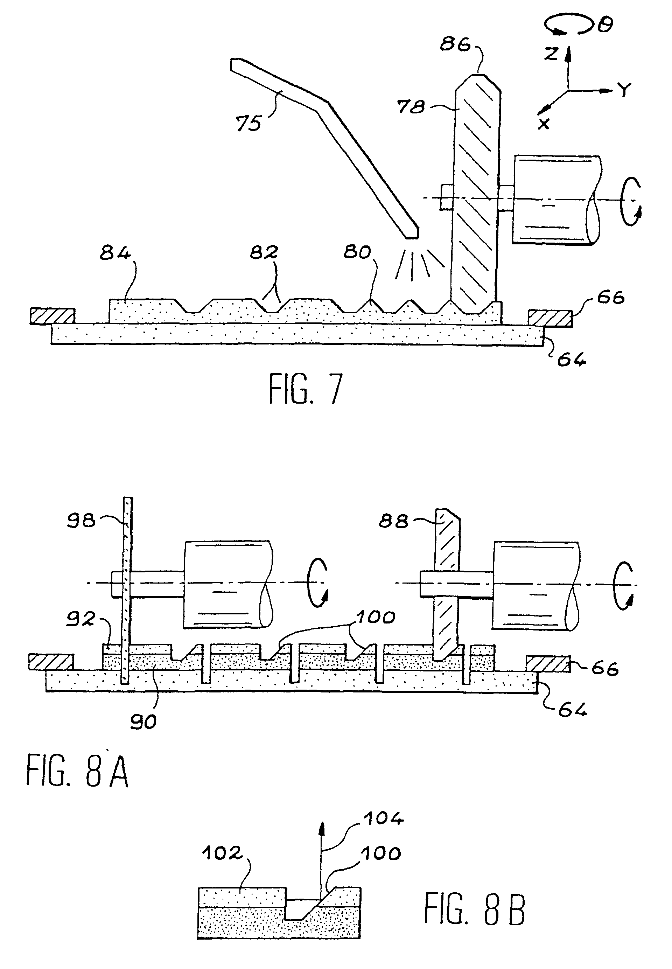

La figure 7, sur laquelle des références identiques à celles des figures 5A-5B y désignent des éléments identiques ou correspondants, est un exemple de polisciage de structures de microprismes 80 ou de micro-miroirs 82 sur un substrat 84. La lame 78 utilisée a un profil en "V" tronqué, présentant une surface plane 86.

La figure 8A, sur laquelle des références identiques à celles des figures 5A-5B y désignent des éléments identiques ou correspondants, représente le principe de fabrication, selon l'invention, de microprismes pour la fabrication collective de puces de microlaser guide d'onde associé avec un micromiroir de renvoi du faisceau.

Une plaque de matériau actif laser 92, associée à un substrat 90, est usinée à l'aide de deux lames 88, 98 fonctionnant par exemple en parallèle. La première définit un micromiroir de renvoi 100, face à chaque émetteur laser 102, tandis que la deuxième lame sépare chaque composant microlaser (avec son micromiroir de renvoi) des composants voisins (chacun associé à son propre miroir de renvoi). Chaque composant individuel peut ensuite émettre un faisceau 104 comme illustré sur la figure 8B.

Une variante du procédé décrit ci-dessus consiste à réaliser une ébauche, comme décrit précédemment et, à fin de finition (ou de polissage), à utiliser une lame ou meule, sans grains d'abrasifs liés dans la matrice, mais en utilisant cette lame comme vecteur d'un abrasif de polissage séparé et réparti le long du trait d'ébauche. Dans ce cas, la lame sans matrice diamantée fait office de support de polissage en entraînant par sa rotation les grains d'abrasif sur chacun de ses flancs. La largeur de la lame est ajustée en fonction de la largeur du trait d'ébauche et de la granulométrie de l'abrasif utilisé (la largeur de lame de finition est choisie plus faible que la largeur du trait d'ébauche). La structure de la lame peut être évidée, ou non.

L'abrasif peut être distribué, soit le long du trait d'ébauche, par projection à la place de l'eau de refroidissement de la lame, sous forme d'une solution liquide, soit recouvrir par exemple la plaquette ébauchée sous forme d'un liquide, d'un gel ou d'une pâte plus compacte. La nature de cet abrasif (alumine, oxyde de cérium, diamant, carbures de silicium ou de bore, ...), dépend de la dureté et de l'état de surface requis pour une application donnée et un type de matériau à usiner.

Une seconde variante du procédé peut être mise en oeuvre après la première étape d'usinage d'ébauche, et à la place ou en complément de l'étape de finition de la surface, en procédant à une attaque chimique superficielle ou à un dépôt planarisant (par exemple : une couche métallique ou des multicouches diélectriques), en fonction des caractéristiques technologiques et des spécifications du dispositif.

Une troisième variante du procédé consiste à utiliser une lame en "U" dont l'extrémité est liée de grains d'abrasif, et la partie latérale (faces parallèles) est liée d'abrasif de plus faible granulométrie. Ce type de lame permet une ébauche plus rapide (du fait du fort grain) et une finition dans le même trait, sur les faces latérales actives.

## Revendications

1. Procédé de fabrication de microcomposants (76, 102) présentant des microreliefs de qualité optique, dans un substrat (62, 82, 92) comportant :
- une première étape de réalisation du micro-relief désiré (70, 72, 74 ; 80, 82 ; 100) pour chaque microcomposant par usinage mécanique du substrat, l'usinage comportant le déplacement d'au moins un outil en translation et de façon parallèle au substrat, et
- simultanément à la première étape, ou après celle-ci, une deuxième étape de découpage du substrat pour séparer les microcomposants.

2. Procédé selon la revendication 1, la première étape d'usinage mécanique comportant au moins deux sous-étapes : une première sous-étape d'ébauche et une deuxième sous-étape de finition.

3. Procédé selon la revendication 1 ou 2, la première étape comportant en outre une étape pour obtenir une qualité optique du micro-relief.

4. Procédé selon l'une des revendications 1 à 3, le micro-relief étant réalisé avec un seul outil (68, 78) déplacé à la surface du substrat.

5. Procédé selon l'une des revendications 1 à 3, le micro-relief étant réalisé par plusieurs outils (88, 98) travaillant simultanément et/ou successivement.

6. Procédé selon l'une des revendications 1 à 5, le micro-relief étant réalisé avec une scie déplacée suivant une direction à la fois.

7. Procédé selon l'une des revendications 1 à 5, les microcomposants étant des microprismes (80, 100).

8. Procédé selon la revendication 7, les microprismes étant réalisés à l'aide d'une lame abrasive à profil en "V" (78).

9. Procédé selon la revendication 6, la scie ayant une lame à faces planes et parallèles, ou ayant au moins une face inclinée.

10. Procédé selon l'une des revendications précédentes, la première étape comportant le passage d'une lame sans grain d'abrasif dans sa matrice, cette lame étant utilisée comme vecteur d'un abrasif de polissage séparé et réparti dans les microreliefs.

11. Procédé selon l'une des revendications précédentes, la première étape comportant en outre une attaque chimique superficielle du substrat.

12. Procédé selon l'une des revendications 1 à 10, la première étape comportant en outre la formation d'un dépôt planarisant sur le substrat.

13. Procédé selon l'une des revendications 1 à 7, comportant l'utilisation d'une lame en "U" dont les parties latérales comportent des premiers grains d'abrasifs, et dont l'extrémité comporte des seconds grains abrasifs de plus forte granulométrie que les premiers.

## Patentansprüche

1. Verfahren zur Herstellung von Mikrobauteilen (76, 102) mit Mikroreliefs von optischer Qualität in einem Substrat (62, 82, 92), umfassend:
- einen ersten Schritt zur Herstellung des gewünschten Reliefs (70, 72, 74; 80, 82; 100) jedes Mikrobauteils durch mechanische Bearbeitung des Substrats, wobei die mechanische Bearbeitung die Translationsbewegung wenigstens eines Werkzeugs parallel zum Substrat umfasst, und
- simultan zum ersten Schritt, oder nach diesem, einen zweiten Schritt des Substratschneidens, um die Mikrobauteile zu trennen.

2. Verfahren nach Anspruch 1, wobei der erste Schritt zur mechanischen Bearbeitung wenigstens zwei Teilschritte umfasst: einen ersten Teilschritt zur Rohteil-Herstellung und einen zweiten Teilschritt zur Fertigstellung.

3. Verfahren nach Anspruch 1 oder 2, wobei der erste Schritt außerdem einen Schritt zur Herstellung einer optischen Qualität des Mikroreliefs umfasst.

4. Verfahren nach einem der Ansprüche 1 bis 3, wobei das Mikrorelief mit einem einzigen Werkzeug (68, 78) hergestellt wird, das auf der Oberfläche des Substrats verschoben wird.

5. Verfahren nach einem der Ansprüche 1 bis 3, wobei das Mikrorelief mittels mehrerer gleichzeitig und/oder nacheinander arbeitender Werkzeuge (88, 98) hergestellt wird.

6. Verfahren nach einem der Ansprüche 1 bis 5, wobei das Mikrorelief mit einer Säge hergestellt wird, die zugleich bzw. gleichzeitig in einer Richtung verschoben wird.

7. Verfahren nach einem der Ansprüche 1 bis 5, wobei die Mikrobauteile Mikroprismen (80, 100) sind.

8. Verfahren nach Anspruch 7, wobei die Mikroprismen mit Hilfe eines Schleifblatts bzw. einer Schleifscheibe mit V-Profil (78) hergestellt werden.

9. Verfahren nach Anspruch 6, wobei die Säge ein Blatt bzw. eine Scheibe mit ebenen und parallelen Flächen oder wenigstens einer schrägen Fläche hat.

10. Verfahren nach einem der vorangehenden Ansprüche, wobei der erste Schritt den Durchgang eines Blatts bzw. einer Scheibe ohne Schleifkörner in der Matrix umfasst, wobei diese Scheibe bzw. dieses Blatt als Träger eines separaten und in den Mikroreliefs verteilten Politur-Schleifmittels benutzt wird.

11. Verfahren nach einem der vorangehenden Ansprüche, wobei der erste Schritt außerdem einen chemischen Angriff der Substratoberfläche umfasst.

12. Verfahren nach einem der vorangehenden Ansprüche, wobei der erste Schritt außerdem die Bildung einer planarisierenden Abscheidung auf dem Substrat umfasst.

13. Verfahren nach einem der Ansprüche 1 bis 7, die Benutzung einer U-förmigen Scheibe umfassend, deren seitliche Teile erste Schleifkörner enthalten, und deren Rand zweite Schleifkörner von höherer Granulometrie als die ersten enthalten.

## Claims

1. Method for the manufacture of microcomponents (76, 102) having microreliefs of an optical quality in a substrate (62, 82, 92) comprising:
- a first step of producing the desired microrelief (70, 72, 74; 80, 82; 100) for each microcomponent by mechanical machining of the substrate, the machining involving the displacement of at least one tool in translation and parallel to the substrate and
- simultaneously with the first step or following the same, a second step of cutting the substrate in order to separate the microcomponents.

2. Method according to claim 1, the first mechanical machining step comprising at least two substeps: a first substep for blank-forming and a second substep for finishing.

3. Method according to claim 1 or 2, the first step further comprising a step for obtaining optical quality for the microrelief.

4. Method according to any of claims 1 to 3, the microrelief being made with a single tool (68, 78) moved at the surface of the substrate.

5. Method according to any of claims 1 to 3, the microrelief being made by several tools (88, 98) working simultaneously and/or in succession.

6. Method according to any of claim 1 to 5, the microrelief being made with a saw moved along one direction at a time.

7. Method according to any of claims 1 to 5, the microcomponents being microprisms (80, 100).

8. Method according to claim 7, the microprisms being made by using a "V" profile abrasive blade (78).

9. Method according to claim 6, the saw having a blade with plane and parallel faces, or having at least an inclined face.

10. Method according to any of the preceding claims, the first step consisting of passing a blade without any abrasive grit in its die, this blade being used as carrier for a separate polishing abrasive distributed in the microreliefs.

11. Method according to any of the preceding claims, the first step further comprising a surface chemical etching of the substrate.

12. Method according to any of claims 1 to 10, the first step further consisting of forming a planarizing coating on the substrate.

13. Method according to any of claims 1 to 7, consisting of using a "U" shaped blade with the side parts comprising first abrasive grits and the end comprising second abrasive grits with a larger particle size than the former.
